Europäisches Patentamt

European Patent Office

Office européen des brevets

(11) Publication number: **0 318 411**
A2

# EUROPEAN PATENT APPLICATION

(21) Application number: 88500114.9

(22) Date of filing: 25.11.88

(51) Int. Cl.4: **G 06 F 15/74**

(30) Priority: 25.11.87 ES 8703357

(43) Date of publication of application:
31.05.89 Bulletin 89/22

(84) Designated Contracting States:
CH DE FR GB IT LI NL SE

(71) Applicant: SIREMA S.A.
Hermanos Bou, 239
E-12003 Castellon (ES)

(72) Inventor: Sacco, Walter Daniel Rodriguez
48, Herrero
Castellon (ES)

(74) Representative: Alonso Langle, Emilio Juan
c/o UDAPI, S.L. Segre, 18, Bajo
E-28002 Madrid (ES)

(54) Procedure and installation for intelligent digital registry where the signals to be registered are converted from analogical into digital ones.

(57) Procedure and installation for intelligent digital registry where the signals to be registered are converted from analogical into digital ones, which makes continuos and permanent registry and with direct visualization of the values that a series of variables of the state of a process take along the time assisted therefor by the digitalization of the signals and data processing methods, in such a way that the form and the registry of the variables are decided therein.

FIG.1

Bundesdruckerei Berlin

**Description**

**PROCEDURE AND INSTALLATION FOR INTELLIGENT DIGITAL REGISTRY WHERE THE SIGNALS TO BE REGISTERED ARE CONVERTED FROM ANALOGICAL INTO DIGITAL ONES**

PURPOSE OF THE INVENTION

The invention relates to a procedure and installation of a intelligent digital registry, making a continuous and permanent registry with direct visualization of the values that process condition variables take along the time, assisted by the signal digitalization and data processing media, in such a way that the form and registry of the variables are decided therein.

BACKGROUND FOR THE INVENTION

The traditional solution used until this moment in order to meet this requirement was the graphic analogical registry in continuous way and on line of the instantaneous values taken by the variable. The scale of magnitude of the variable to be registered is represented widthwise on the paper, its instantaneous value being given by the tip or inscription bolster. The temporal data of the registry is given by the advance speed of the paper in a longitudinal way.

This traditional solution has the following inconvenients:

1u) The registered signal is an exact replica of the instantaneous values taken by the variable to be registered, which is not always the most suitable data to document the process.

2u) The registry is continuous on line, which involves an important consumption of paper, ink and a permanent mechanical wear of the registry system (bearing, gears, belts, etc) which requieres a preventive and permanent maintenance and frequent fortuitous repairs.

3u) In order to obtain the registry of transients, the paper dragging speed has a practical minimun fixed by the process. This can cause the registry length at the end of the day to be of several meters, creating serious problems for long-term file and also for its analysis or evaluation if it is necessary.

4u) With the exception of the monochannel registers (a single variable), the direct reading of the variable in actual units is impossible, since the value is expressed as a length in a certain scale.

5u) The number of variables that a registry unit can cover is limited practically by the problems that the eventual superposition of the variable registries creates. The commercial version available cover until 32 variables, with polychromatic discrete numerical printing techniques that obtain mediocre results.

Recently a new generation of register, called intelligent, has appeared in the market, which incorporates a digital system to obtain the instataneous values of the variable to be registered.

In these registers, the conventional analogical direct obtention has been substituded by digital systems that could be configured by the user to obtain analogical values, the philosofy of continuos on line graphical registry of the instantaneous values, and the way they are obtained, which do not resolve the problems created by the conventional registry.

DESCRIPTION OF THE INVENTION

The intelligent Digital Register (RDI) incorporated a series of new elements into the conventional treatment of the signals given by the conventional registers:

1u) The instantaneous values of the variable to be registered are digitally processed, before its registry, to obtain the value that best represents the temporal evolution of the phisical magnitude to be documented. This processing is specifically adjusted to the characteristics of the process to be registered.

2u) Once the value to be registeres has been obtained, the equipment decides on the basis of the temporal evolution that it has had, whether it must be registered or not. If the value obtained shows the constancy of the constancy of the supervised variable it is not printed, if, on the contrary, the instantaneous value or the processed value has undergone any change, the register will proceed to its registry, the real actual time whereupon the change has taken place and the numerical value taken by the variable in question.

This new conception of the register allows a real construction of it as two totally independent units:

1u) The unit to collect data with a personal program, which functions as register.

2u) The registering unit which in this case is a printer of conventional line.

The conception of the RDI completely resolves problems that until now have been impossible to solved with registers available in the market, that is:

1u) The amount of paper generated is the minimun necessary to obtain the complete documentation of the process. This minimizes the consumption of paper, ink and mechanical wear of the printing system.

2u) The system collects every detail of the fast transients of the process,since it is capable of reacting to any variations of the instantaneous values, whereas mantaining a minimum paper consumption on a long term, since it does not print in steady periods.

3u) The direct numerical printing phisical units and only of the variations, allows a quick and accurate analysis with minimum effort, the instantaneous variations of the magnitudes and the instant produced.

4u) As the output element is a conventional printer, maintenance problems are practically eliminated.

2

5u) The number of channels that a unit could attend is practically infinite, since there do not exist problems of representation as described with respect to conventional registers.

Besides, fulfilling the performance as described above, the philosophy of the design of the intelligent digital register also allows:

1u) Installating the data collection unit and the printing unit in the most appropiate places according to the functions they carry on. These places could be several kilometers apart since the interconnection of the units only requires a pair of conducter-wires (a paratelephonic group).

2u) To store the data to be registered in magnetic support or by means of a plant control central computer.

PRACTICAL EXAMPLE

As an example described below is an application of the intelligent digital register to register the radiactive exposure rates.

In this application, the system must register the analogical signals from 54 monitors of environmental radiation monitors with Geiger-Müller detector.

The analogical signals under tension sent by the monitors are standarized to a range of variation of 0 to -1 Volts, corresponding in phisical units to logaritmical scales of 4 decades with the following ranges:
a) 0.01 mR/h to 100 mR/h
b) 0.1 mR/h to 1.000 mR/h
c) 1 mR/h to 10.000 mR/h

The original solution to solve this problem was to install two conventional registers of 32 channels each of the alphanumerical-coding multipoint type and continuous printing on paper with logarithmical scale, of special make.

Table I corresponds to a real printing obtained through this system.

3

The disadvantages of this solution are:

1u) In most monitorized areas, the exposure rates are practically zero and, therefore, the instantaneous indications given by the monitors are affected by considerable statistical fluctuation ( 80-100 % avarege value). This erratic indication, characteristic of the radioactive phenomena, is inevitably gathered by the conventional register, obteining thereby a graphical registration with a very low definition (the printing of a channel notably changes from a instant to another.

2u) Most channels of one same range indicate virtually the -same thing and, therefore, there produces an are of systematic printing wherein the alphanumeric characters of said --channels are superimposed, which, added to the statistical -fluctuation of the registry point, damages even more the graphical image of the phenomenon to be registered.

3u) The speed of the paper is set to the minimum compatible with the possibility of registering fast transients so the amount of paper generated after some days is difficult to -handle and file.

4u) In spite of the fact that the number of decades of the -different channels coincide, the printing on the register paper in one coordinate can represent the value n, 10n, or 100n, making the reading and direct interpreting of the data difficult and increasing the possibility of error in the evaluation of the records.

5u) Owing to electrical conducting of signals, the register must be installed in the control room; far from the radiactive protection department, specific and final user of the -system.

The RDI, installed to substitute for the conventional register is provided with a digital-analogical converter of 64 inputs.

As a direct-reading registry element, two in-line printers -are provided to originally register 54 channels. The first -column is reserved for the printing and the followings 27 columns for each channel to be registered. Tables II, III and IV show three actual prints obtained through this registring element.

Table II

EP 0 318 411 A2

DATE 30/09/1988

REGISTRY OF GROSS ACTIVITES IN mR/H OF THE SYSTEM FOR THE DETECTION OF RADIATION IN AREA D-21

| MPL | N011 | N012 | N013 | N021 | N022 | N023 | N024 | N014 | N015 | N025 | N026 | N027 | N028 | N029 | N016 | N017 | N071 | N030 |
|---|---|---|---|---|---|---|---|---|---|---|---|---|---|---|---|---|---|---|
| LOCATION | REACTR | REACTR | REACTR | POZOSC | POZOSC | REACTR | REACTR | REACTR | REACTR | REACTR | REACTR | POZOSC | POZOSC | POZOSC | REACTR | REACTR | REACTR | AUXILS |
| BOTTOM (mR/H) | 0,00 | 0,00 | 0,00 | 1,04 | 1,05 | 0,00 | 0,00 | 0,00 | ------ | 0,00 | 0,00 | 0,00 | 0,00 | ------ | ------ | ------ | ------ | -- --- |
| CHANNEL | 01 | 02 | 03 | 04 | 05 | 06 | 07 | 08 | 09 | 10 | 11 | 15 | 16 | 17 | 18 | 19 | 20 | 21 |

HOUR

| HOUR | N011 | N012 | N013 | N021 | N022 | N023 | N024 | N014 | N015 | N025 | N026 | N027 | N028 | N029 | N016 | N017 | N071 | N030 |
|---|---|---|---|---|---|---|---|---|---|---|---|---|---|---|---|---|---|---|
| 08:36:40 | ------ | ------ | ------ | ------ | ------ | 0,11 | ------ | ------ | ------ | ------ | ------ | ------ | ------ | ------ | ------ | ------ | ------ | -- ----- |
| 08:36:40 | 0,70 | 0,19 | 0,26 | 3,70 | 0,33 | 1,19 | 1,77 | 2,37 | ------ | 0,59 | 0,78 | 0,18 | 0,70 | ------ | ------ | ------ | ------ | -- ---- |
| 09:00:00 | 0,71 | 0,20 | 0,26 | 3,65 | 0,55 | 1,19 | 2,00 | 2,74 | ------ | 0,65 | 0,79 | 0,18 | 0,70 | ------ | ------ | ------ | ------ | -- ---- |
| 10:00:00 | 0,71 | 0,20 | 0,25 | 3,65 | 0,55 | 1,11 | 2,25 | 2,27 | ------ | 0,66 | 0,77 | 0,18 | 0,70 | ------ | ------ | ------ | ------ | -- --- |
| 11:00:00 | 0,71 | 0,20 | 0,25 | 3,65 | 0,55 | 1,11 | 1,92 | 2,32 | ------ | 0,66 | 0,76 | 0,18 | 0,70 | ------ | ------ | ------ | ------ | -- ---- |
| 12:00:00 | 0,69 | 0,20 | 0,26 | 3,67 | 0,55 | 1,11 | 1,93 | 2,18 | ------ | 0,67 | 0,77 | 0,18 | 0,69 | ------ | ------ | ------ | ------ | -- ---- |
| 13:00:00 | 0,70 | 0,20 | 0,26 | 3,66 | 0,54 | 1,12 | 1,96 | 2,29 | ------ | 0,65 | 0,77 | 0,18 | 0,69 | ------ | ------ | ------ | ------ | -- ---- |
| 14:00:00 | 0,71 | 0,20 | 0,26 | 3,54 | 0,55 | 1,11 | 1,97 | 2,23 | ------ | 0,65 | 0,77 | 0,18 | 0,69 | ------ | ------ | ------ | ------ | -- ---- |
| 15:00:00 | 0,70 | 0,19 | 0,26 | 3,52 | 0,56 | 1,20 | 1,97 | 2,22 | ------ | 0,65 | 0,77 | 0,18 | 0,69 | ------ | ------ | ------ | ------ | -- ---- |
| 15:02:00 | ------ | ------ | ------ | ------ | ------ | 2,64 | ------ | ------ | ------ | ------ | ------ | ------ | ------ | ------ | ------ | ------ | ------ | -- ---- |
| 15:02:05 | ------ | ------ | ------ | ------ | ------ | 1,10 | ------ | ------ | ------ | ------ | ------ | ------ | ------ | ------ | ------ | ------ | ------ | -- ---- |
| 16:00:00 | 0,71 | 0,21 | 0,27 | 3,60 | 0,55 | 1,12 | 2,01 | 2,18 | ------ | 0,65 | 0,76 | 0,18 | ------ | ------ | ------ | ------ | ------ | -- ---- |
| 16:24:00 | ------ | ------ | ------ | ------ | ------ | ------ | ------ | ------ | ------ | ------ | ------ | ------ | ------ | ------ | ------ | ------ | ------ | -- ---- |
| 16:50:40 | ------ | ------ | ------ | ------ | ------ | ------ | ------ | ------ | ------ | ------ | ------ | ------ | ------ | ------ | ------ | ------ | ------ | -- ---- |
| 17:00:00 | 0,72 | 0,20 | 0,26 | 3,59 | 0,55 | 1,11 | 1,96 | 2,24 | ------ | 1,39 | 0,78 | 0,18 | ------ | ------ | ------ | ------ | ------ | -- ---- |
| 17:00:05 | ------ | ------ | ------ | ------ | ------ | ------ | ------ | ------ | ------ | 0,67 | ------ | ------ | ------ | ------ | ------ | ------ | ------ | -- ---- |
| 17:07:10 | ------ | ------ | ------ | ------ | ------ | ------ | ------ | ------ | ------ | ------ | ------ | ------ | ------ | ------ | ------ | ------ | ------ | -- --- |
| 17:32:15 | ------ | ------ | ------ | ------ | ------ | 1,11 | ------ | ------ | ------ | ------ | ------ | ------ | ------ | ------ | ------ | ------ | ------ | -- ---- |
| 18:00:00 | 0,71 | 0,21 | 0,27 | 3,60 | 0,56 | 1,13 | 1,95 | 2,19 | ------ | 0,66 | 0,77 | 0,18 | 0,70 | ------ | ------ | ------ | ------ | -- ---- |
| 19:00:00 | 0,71 | 0,21 | 0,25 | 3,60 | 0,56 | 1,16 | 1,94 | 2,20 | ------ | 0,66 | 0,77 | 0,18 | 0,69 | ------ | ------ | ------ | ------ | -- ---- |
| 20:00:00 | 0,71 | 0,19 | 0,26 | 3,53 | 0,56 | 1,12 | 1,93 | 2,30 | ------ | 0,65 | 0,77 | 0,18 | 0,69 | ------ | ------ | ------ | ------ | -- ---- |
| 21:00:00 | 0,71 | 0,20 | 0,25 | 3,59 | 0,55 | 1,12 | 1,96 | 2,31 | ------ | 0,64 | 0,77 | 0,18 | 0,69 | ------ | ------ | ------ | ------ | -- ---- |
| 21:05:05 | ------ | ------ | ------ | ------ | ------ | 2,76 | ------ | ------ | ------ | ------ | ------ | ------ | ------ | ------ | ------ | ------ | ------ | -- ---- |
| 21:05:10 | ------ | ------ | ------ | ------ | ------ | 1,41 | ------ | ------ | ------ | ------ | ------ | ------ | ------ | ------ | ------ | ------ | ------ | -- ---- |
| 22:00:00 | 0,71 | 0,20 | 0,24 | 3,61 | 0,55 | 1,19 | 1,95 | 2,18 | ------ | 0,65 | 0,77 | 0,18 | 0,70 | ------ | ------ | ------ | ------ | -- ---- |
| 23:00:00 | 0,71 | 0,20 | 0,25 | 3,62 | 0,55 | 1,12 | 1,96 | 2,13 | ------ | 0,67 | 0,78 | 0,17 | 0,68 | ------ | ------ | ------ | ------ | -- ---- |

Table III

EP 0 318 411 A2

DATE: 04/10/1988

REGISTRY OF GROSS ACTIVITES IN mR/H OF THE SYSTEM FOR THE DETECTION OF RADIATION IN AREA D-21

| MPL | NO11 | NO12 | NO13 | NO21 | NO22 | NO23 | NO24 | NO14 | NO15 | NO25 | NO26 | NO51 | NO52 | NO53 | NO27 | NO28 | NO29 | NO16 |
|---|---|---|---|---|---|---|---|---|---|---|---|---|---|---|---|---|---|---|
| LOCATION | REACTR | REACTR | REACTR | PZO.SC | PZO.SC | REACTR | REACTR | REACTR | REACTR | REACTR | REACTR | REACTR | REACTR | REACTR | PZO.SC | PZO.SC | PZO.SC | REACTR |
| BOTTOM (mR/H) | 0,00 | 0,00 | 0,00 | 1,04 | 1,05 | 0,00 | 0,00 | 0,00 | ----- | 0,00 | 0,00 | 0,00 | ----- | ----- | ----- | ----- | ----- | ----- |
| CHANNEL | 01 | 02 | 03 | 04 | 05 | 06 | 07 | 08 | 09 | 10 | 11 | 12 | 13 | 14 | 15 | 16 | 17 | 18 |
| HOUR | | | | | | | | | | | | | | | | | | |
| 08:15:00 | 0,70 | 0,20 | 0,26 | 3,53 | 0,56 | 1,14 | 1,95 | 2,23 | ----- | 0,55 | 0,77 | 505 | ----- | ----- | 0,17 | 0,69 | ----- | ----- |
| 09:15:00 | 0,69 | 0,30 | 0,25 | 3,59 | 0,55 | 1,13 | 1,96 | 2,36 | ----- | 0,56 | 0,77 | 525 | ----- | ----- | 0,17 | 0,69 | ----- | ----- |
| 09:20:15 | ----- | ----- | ----- | ----- | ----- | ----- | ----- | ----- | ----- | ----- | ----- | 699 | ----- | ----- | ----- | ----- | ----- | ----- |
| 09:40:24 | ----- | ----- | ----- | ----- | ----- | ----- | ----- | ----- | ----- | ----- | ----- | 584 | ----- | ----- | ----- | ----- | ----- | ----- |
| 10:15:00 | 0,69 | 0,20 | 0,25 | 3,58 | 0,54 | 1,11 | 1,96 | 2,33 | ----- | 0,65 | 0,78 | 555 | ----- | ----- | 0,17 | 0,70 | ----- | ----- |
| 11:15:00 | 0,72 | 0,24 | 0,27 | 3,56 | 0,50 | 1,13 | 1,99 | 2,42 | ----- | 0,65 | 0,77 | 572 | ----- | ----- | 0,18 | 0,71 | ----- | ----- |
| 12:15:00 | 0,72 | 0,24 | 0,27 | 3,62 | 0,50 | 1,12 | 1,95 | 2,21 | ----- | 0,61 | 0,75 | 625 | ----- | ----- | 0,19 | 0,69 | ----- | ----- |
| 13:15:00 | 0,72 | 0,24 | 0,27 | 3,59 | 0,55 | 1,12 | 1,95 | 2,22 | ----- | 0,66 | 0,78 | 634 | ----- | ----- | 0,19 | 0,69 | ----- | ----- |
| 14:15:00 | 0,72 | 0,18 | 0,27 | 3,55 | 0,56 | 1,12 | 1,94 | 2,21 | ----- | 0,66 | 0,78 | 832 | ----- | ----- | 0,17 | 0,69 | ----- | ----- |
| 15:15:00 | 0,69 | 0,20 | 0,25 | 3,63 | 0,56 | 1,11 | 1,97 | 2,21 | ----- | 0,66 | 0,78 | 810 | ----- | ----- | 0,17 | 0,71 | ----- | ----- |
| 15:25:45 | ----- | ----- | ----- | ----- | ----- | ----- | ----- | ----- | ----- | ----- | ----- | 770 | ----- | ----- | ----- | ----- | ----- | ----- |
| 16:15:00 | 0,73 | 0,20 | 0,26 | 3,60 | 0,55 | 1,11 | 1,95 | 2,24 | ----- | 0,63 | 0,78 | 748 | ----- | ----- | 0,17 | 0,71 | ----- | ----- |
| 17:15:00 | 0,69 | 0,20 | 0,24 | 3,60 | 0,55 | 1,12 | 1,93 | 2,28 | ----- | 0,67 | 0,77 | 741 | ----- | ----- | 0,18 | 0,71 | ----- | ----- |
| 18:15:00 | 0,68 | 0,20 | 0,26 | 3,57 | 0,56 | 1,11 | 1,96 | 2,36 | ----- | 0,66 | 0,77 | 745 | ----- | ----- | 0,18 | 0,71 | ----- | ----- |
| 19:15:00 | 0,69 | 0,21 | 0,25 | 3,60 | 0,55 | 1,01 | 1,92 | 2,35 | ----- | 0,66 | 0,77 | 736 | ----- | ----- | 0,18 | 0,70 | ----- | ----- |
| 19:20:01 | ----- | ----- | ----- | ----- | ----- | ----- | ----- | ----- | ----- | ----- | ----- | 492 | ----- | ----- | ----- | ----- | ----- | ----- |
| 19:23:57 | ----- | ----- | ----- | ----- | ----- | ----- | ----- | ----- | ----- | ----- | ----- | 374 | ----- | ----- | ----- | ----- | ----- | ----- |
| 19:45:34 | ----- | ----- | ----- | ----- | ----- | ----- | ----- | ----- | ----- | ----- | ----- | 321 | ----- | ----- | ----- | ----- | ----- | ----- |
| 20:15:00 | ----- | ----- | ----- | ----- | ----- | ----- | ----- | ----- | ----- | ----- | ----- | 250 | ----- | ----- | ----- | ----- | ----- | ----- |
| 20:17:22 | ----- | ----- | ----- | ----- | ----- | ----- | ----- | ----- | ----- | ----- | ----- | 435 | ----- | ----- | ----- | ----- | ----- | ----- |
| 20:22:46 | ----- | ----- | ----- | ----- | ----- | ----- | ----- | ----- | ----- | ----- | ----- | 345 | ----- | ----- | ----- | ----- | ----- | ----- |
| 21:15:00 | ----- | ----- | ----- | ----- | ----- | ----- | ----- | ----- | ----- | ----- | ----- | 335 | ----- | ----- | ----- | ----- | ----- | ----- |
| 21:23:45 | ----- | ----- | ----- | ----- | ----- | ----- | ----- | ----- | ----- | ----- | ----- | 245 | ----- | ----- | ----- | ----- | ----- | ----- |
| 22:15:00 | ----- | ----- | ----- | ----- | ----- | ----- | ----- | ----- | ----- | ----- | ----- | 188 | ----- | ----- | ----- | ----- | ----- | ----- |
| 23:15:00 | 0,72 | 0,20 | 0,25 | 3,58 | 0,55 | 1,11 | 1,95 | 2,31 | ----- | 0,65 | 0,77 | 168 | 0,17 | 0,70 | ----- | ----- | ----- | ----- |

## Table IV

DATE: 06/10/1988

REGISTRY OS GROSS ACTIVITES IN mR/H OF THE SYSTEM FOR THE DETECTION OF RADIATION IN AREA D-21

| MPI. | N011 | N012 | N013 | N021 | N022 | N023 | N024 | N014 | N015 | N025 | N026 | N051 | N052 | N053 | N027 | N028 | N029 | N016 |
|---|---|---|---|---|---|---|---|---|---|---|---|---|---|---|---|---|---|---|
| LOCATION | REACTR | REACTR | REACTR | PZO.SC | PZO.SC | REACTR | REACTR | REACTR | REACTR | REACTR | REACTR | REACTR | REACTR | REACTR | PZO.SC | PZO.SC | PZO.SC | REACTR |
| BOTTOM (mR/H) | 0,00 | 0,00 | 0,00 | 1,04 | 1,05 | 0,00 | 0,00 | 0,00 | ----- | 0,00 | 0,00 | 0,00 | ----- | ----- | ----- | ----- | ----- | ----- |
| CHANNEL | 01 | 02 | 03 | 04 | 05 | 06 | 07 | 08 | 09 | 10 | 11 | 12 | 13 | 14 | 15 | 16 | 17 | 18 |
| HOUR | | | | | | | | | | | | | | | | | | |
| 08:06:40 | ----- | ----- | ----- | ----- | ----- | 0,11 | ----- | ----- | ----- | ----- | ----- | 542 | ----- | ----- | ----- | ----- | ----- | ----- |
| 08:36:40 | 0,70 | 0,19 | 0,26 | 3,70 | 0,55 | 1,19 | 1,97 | 2,37 | ----- | 0,57 | 0,79 | 579 | ----- | 0,19 | 0,70 | ----- | ----- | ----- |
| 09:00:00 | 0,71 | 0,20 | 0,26 | 3,65 | 0,55 | 1,19 | 2,00 | 2,74 | ----- | 0,65 | 0,78 | 630 | ----- | 0,19 | 0,70 | ----- | ----- | ----- |
| 10:00:00 | 0,71 | 0,20 | 0,25 | 3,65 | 0,55 | 1,11 | 1,95 | 2,57 | ----- | 0,65 | 0,77 | 654 | ----- | 0,18 | 0,70 | ----- | ----- | ----- |
| 11:00:00 | 0,71 | 0,20 | 0,25 | 3,65 | 0,55 | 1,11 | 1,92 | 2,57 | ----- | 0,65 | 0,77 | 525 | ----- | 0,18 | 0,70 | ----- | ----- | ----- |
| 12:00:00 | 0,69 | 0,20 | 0,26 | 3,65 | 0,55 | 1,11 | 1,97 | 2,30 | ----- | 0,65 | 0,77 | 450 | ----- | 0,18 | 0,70 | ----- | ----- | ----- |
| 13:00:00 | 0,70 | 0,20 | 0,26 | 3,66 | 0,54 | 1,12 | 1,96 | 2,29 | ----- | 0,65 | 0,77 | 385 | ----- | 0,18 | 0,69 | ----- | ----- | ----- |
| 14:00:00 | 0,71 | 0,20 | 0,26 | 3,54 | 0,55 | 1,11 | 1,97 | 2,23 | ----- | 0,65 | 0,77 | 350 | ----- | 0,19 | 0,69 | ----- | ----- | ----- |
| 15:00:00 | 0,70 | 0,19 | 0,26 | 3,52 | 0,56 | 1,20 | 1,97 | 2,22 | ----- | 0,65 | 0,77 | 354 | ----- | 0,18 | 0,69 | ----- | ----- | ----- |
| 15:02:00 | ----- | ----- | ----- | ----- | ----- | 2,64 | ----- | ----- | ----- | ----- | ----- | 325 | ----- | ----- | ----- | ----- | ----- | ----- |
| 15:02:05 | ----- | ----- | ----- | ----- | ----- | 1,10 | ----- | ----- | ----- | ----- | ----- | 320 | ----- | ----- | ----- | ----- | ----- | ----- |
| 16:00:00 | 0,71 | 0,21 | 0,29 | 3,60 | 0,55 | 1,12 | 2,01 | 2,18 | ----- | 0,65 | 0,79 | 282 | ----- | 0,18 | 0,68 | ----- | ----- | ----- |
| 16:24:00 | ----- | ----- | ----- | ----- | ----- | ----- | ----- | ----- | ----- | ----- | ----- | 234 | ----- | ----- | ----- | ----- | ----- | ----- |
| 16:50:40 | ----- | ----- | ----- | ----- | ----- | ----- | ----- | ----- | ----- | ----- | ----- | 284 | ----- | ----- | ----- | ----- | ----- | ----- |
| 17:00:00 | 0,73 | 0,20 | 0,26 | 3,59 | 0,55 | 1,11 | 1,96 | 2,24 | ----- | 1,39 | 0,78 | 374 | ----- | 0,18 | 0,70 | ----- | ----- | ----- |
| 17:00:05 | ----- | ----- | ----- | ----- | ----- | ----- | ----- | ----- | ----- | ----- | ----- | ----- | ----- | ----- | ----- | ----- | ----- | ----- |
| 17:07:10 | ----- | ----- | ----- | ----- | ----- | ----- | ----- | ----- | ----- | ----- | ----- | 372 | ----- | ----- | ----- | ----- | ----- | ----- |
| 17:11:55 | ----- | ----- | ----- | ----- | ----- | ----- | ----- | ----- | ----- | ----- | ----- | 427 | ----- | ----- | ----- | ----- | ----- | ----- |
| 17:16:10 | ----- | ----- | ----- | ----- | ----- | ----- | ----- | ----- | ----- | ----- | ----- | 481 | ----- | ----- | ----- | ----- | ----- | ----- |
| 17:17:15 | ----- | ----- | ----- | ----- | ----- | 1,11 | ----- | ----- | ----- | ----- | ----- | 1015 | ----- | ----- | ----- | ----- | ----- | ----- |
| 18:00:00 | 0,71 | 0,21 | 0,27 | 3,60 | 0,56 | 1,13 | 1,95 | 2,24 | ----- | 0,66 | 0,77 | 1070 | ----- | 0,18 | 0,70 | ----- | ----- | ----- |
| 19:00:00 | 0,71 | 0,21 | 0,25 | 3,60 | 0,56 | 1,16 | 1,94 | 2,24 | ----- | 0,66 | 0,77 | 1130 | ----- | 0,18 | 0,70 | ----- | ----- | ----- |
| 20:00:00 | 0,71 | 0,19 | 0,26 | 3,63 | 0,55 | 1,12 | 1,93 | 2,30 | ----- | 0,65 | 0,77 | 1030 | ----- | 0,18 | 0,69 | ----- | ----- | ----- |
| 21:00:00 | 0,71 | 0,20 | 0,25 | 3,59 | 0,55 | 1,12 | 1,93 | 2,30 | ----- | 0,64 | 0,77 | 1030 | ----- | 0,18 | 0,69 | ----- | ----- | ----- |
| 22:00:00 | 0,71 | 0,20 | 0,24 | 3,61 | 0,55 | 1,19 | 1,95 | 2,18 | ----- | 0,65 | 0,77 | 997 | ----- | 0,18 | 0,70 | ----- | ----- | ----- |
| 23:00:00 | 0,71 | 0,20 | 0,25 | 3,62 | 0,55 | 1,12 | 1,96 | 2,12 | ----- | 0,67 | 0,78 | 954 | ----- | 0,17 | 0,69 | ----- | ----- | ----- |

For long-term record, the printed data are input into the radioprotection management computer.

The instantaneous values obtained each five seconds are processed in an algorythmic of avaraging and validation for printing, which operates on the basis of 4 variable defined following way:

a) Instantaneous value. Value of the variable to be registered obtained by the on-line digital-analogical converter each five seconds.

b) Calculated average. Arithmethical average of the instantaneous values calculated so as to obtain a fixed incertaincy independent from the absolut value of said average.

c) Printed value. The last value printed that indicated the variable to be registered.

d) Last average calculated. During the lapse of time wherein a new average is calculated, the one calculated before is kept with this name.

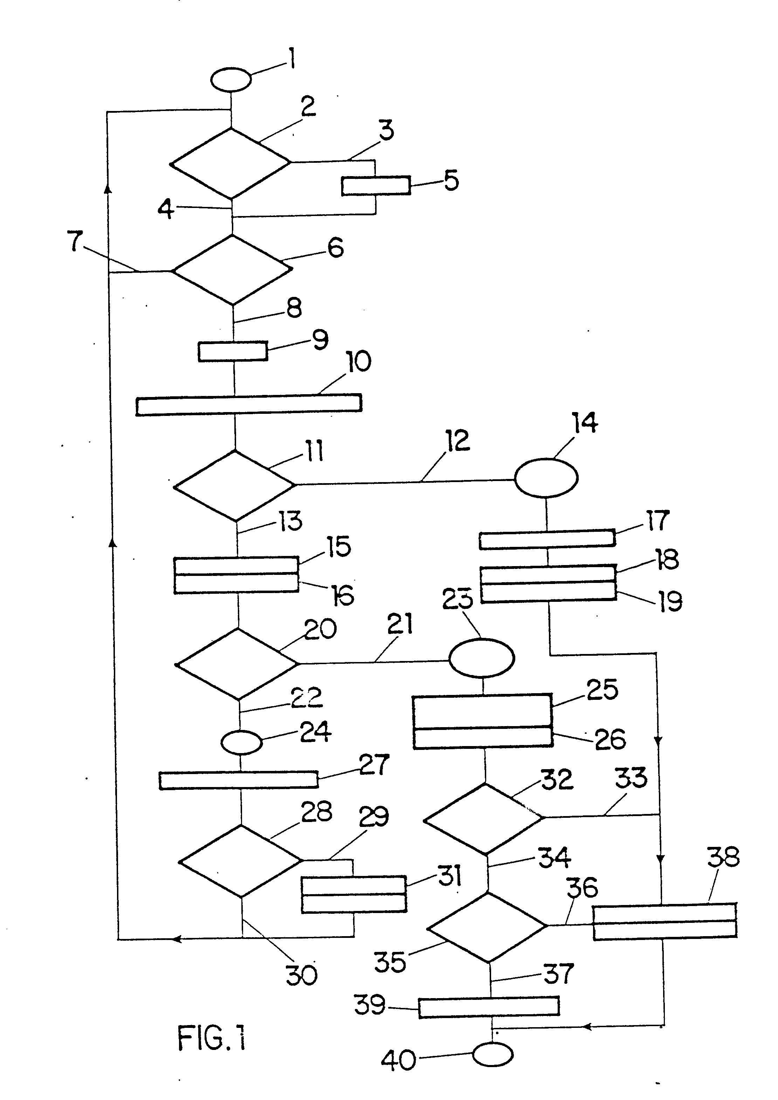

The validation and calculation process described for a channel is repeated in the same way for the other 53 channels, as represented in Figure 1, which corresponds to a RDI flow diagram of exposure rates, and in which the references have the following meanings:

1 Input
2 Printing
3 Yes
4 No
5 Printing
6 5 seconds elapsed
7 No
8 Yes
9 Reading
10 Channel m collects instaneous value.
11 Transient
12 Yes
13 No
14 Instantaneous printing
15 VI + Ins    Tns
16 n + 1    n
17 V. Instantaneous    V. printed
18 V. Instantaneous    Instantaneous
19 n = 1
20 Average calculation
21 Yes
22 No
23 Average calculation
24 Clock
25 Average calculation $= \dfrac{\text{1ns}}{\text{n}}$
26 n = 1
27 Update inernal clock
28 Clock printing
29 Yes
30 No
31 Print all the channels
32 Average calculation 1,1 V. printed
33 Yes
34 No

The instantaneous value of the variable to be processed is read, acceding to the corresponding channel of the digital analogical converter.

Once the instantaneous value is digitally obtained, the register determines whether its numerical value exceeds the negative or positive variation standards with respect to the printed value, so as to detect a possible quick transient.

In an affirmative case the instantaneous value obtained is taken as real value of the variable and the order is given to print said value in the corresponding channel. At the same time, the aforementioned instantaneous value is stored as printed value, and the arithmetical average calculation begins again.

If, on the contrary, the constancy of the instantaneous value has been met, the value obtained is incorporated and added to the sum for the calculation of the arithmetical average.

Once the value has been incorporated it is verified if the sum fulfills numerical criterion that assures the specified dispersion value for the average value; if so, the arithmetical average is calculated.

Once the average has been calculated, the fulfillment of the constancy of averages is verified by comparing them with the printed values, following the same procedure as in the case of instantaneous value; if there has been any variation, order is given for printing and recording of the calculated average as printed value, whereupon the calculation cycle recommences; in an opposite case, the average calculated is safeguarded as the last average calculated and a new average calculation begins.

This processing and selection of the printing as per constancy criteria in the values of the variable to be registered allows:

1.- Total definition of the values taken by the registered values because of eliminating the statiscal fluctuation in the low areas of the measure scale, without losing the capacity of detecting quick transients.

2.- The direct reading and the following of the process evolution in an inmediate and accurate way because of having numerical values perfectly differenciated for each channel and referred temporarily.

3.- The amount of paper generated is the minimum compatible with the quality of documentation required: a) Registry of transients of duration longer than or equal to 5 seconds. b) Values of exposures rates with an uncertainly of less than 10% of its value.

4.- The need of filing compact huge amount of paper for long-term record is eliminated, since the numerical registry is input directly to the radioprotection management computer.

5.- The data registered is obtained in the most proper side for its use; in this case, the on-line printers are installed in the radioprotection department.

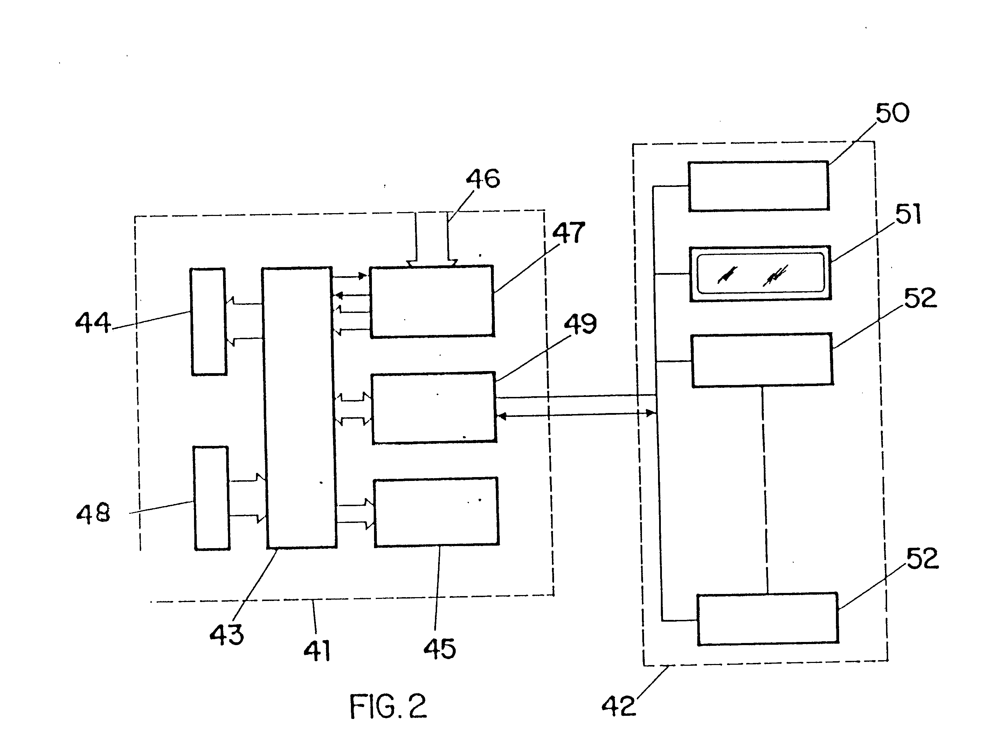

Figure 2 represents a block diagram which can be used in the procedure of the invention, valid for any kind of installation. In the drawing the data collecting unit 41 and their recording and representing unit 42 are represented. Both units are comunicated through a data-series bus transference usually composed of a telephonic couple.

The data collection unit is also composed of a microprocessor 43, from which a visualizer or "display" 44 is excited through a parallel communication bus, and through another one of the same type, the information is put    memory of system 45 which can be of any type (d    cassette, etc.) The data arrive, as per arrow 46, microprocessor digitalized by the analogical-digital c    48 whcih in return receives them in an analogical way through a communication loop from the field sensors. The microprocessor is controlled by a keyboard 48. Reference 49 shows the interface of communication of series.

The unit of represtation and registry 42 id formed by various equipments among which are the principle plant computer 50 which brings general data of the principal installation and which is assited by the register, a control monitor of keyboard 51 and printers 52, variable in number depending on the need.

Now that the nature of the invention, together wiht the procedures of its practical implementation, has been sufficiently described, it must be noted that the arrangement described above are susceptible of modifications in detail as long as these do not affect its fundamental principle.

## Claims

1.- Procedure and instalation for intelligent digital registry, where the signals to be registered are converted from analogical into digital ones, characterized by the fact that these signals undergo, before its registry, a process of selection in accordance with the temporary evolution and of the physical magnitude, the signal to be registered being decided according to a pre-established program.

2.- Procedure according to claim 1 characterized by no representing the repetitive values during steady periods.

3.- Procedure according to claim 1 wherein the instantaneous value is registered when its difference from the last value registered exceeds a pre-stablished tolerance.

4.- Procedure according to claim 1 wherein the instantaneous values are processed in such a way that an average of said values is obtained this average value being registered in case where its diference exceeds.

5.- Procedure according to claim 4 wherein the consecutive average values are processed to determine the temporal gradient of the variable, proceding to its registry when the gradient surpasses a specific value.

6.- Procedure according to claim 4 or 5 wherein the calculation of the average is carried out only when sufficient number of instantaneous values assuring the dispersion value spcified in each case has been achieved.

7.- Procedure according to claim 1, wherein with the registry, the time of occuring of the singularities of registered variable is expplicitly specified.

8.- Procedure and installation according    wherein the location of the registry equipment an    is indepent of the location of the data collection e    .

FIG.1

FIG. 2

EP 0 318 411 A2